(19) Europäisches Patentamt

European Patent Office

Office européen des brevets

(11) EP 0 757 439 A2

(12) EUROPEAN PATENT APPLICATION

(43) Date of publication:
05.02.1997 Bulletin 1997/06

(51) Int. Cl.$^6$: H03H 11/24, H03G 1/00

(21) Application number: 96305106.5

(22) Date of filing: 11.07.1996

(84) Designated Contracting States:
DE FR GB

(30) Priority: 31.07.1995 JP 194865/95

(71) Applicant: Oki Electric Industry Co., Ltd.
Tokyo (JP)

(72) Inventor: Kasashima, Masaaki,
Oki Electric Ind. Co., Ltd.
Minato-ku, Tokyo (JP)

(74) Representative: Boydell, John Christopher
Stevens, Hewlett & Perkins
1 Serjeants' Inn
Fleet Street
London EC4Y 1LL (GB)

(54) A variable resistor circuit, a variable attenuator circuit and a variable gain amplifier

(57) The invention concerns a variable attenuator circuit of the type incorporating an amplifier which amplifies an input control voltage and is composed of one or more transistors (Q1), of which a first transistor (Q2) is used as a resistor, and which has a control electrode supplied with the control voltage to be amplified, the parameters being set such that the value of the resistance between first and second electrodes (T3,T4) is varied according to the supplied control voltage. In such a circuit, there may be provided a variable resistor circuit capable of compensating for product variations in the characteristics of the first transistor (Q2) used as the resistor and for variations in temperature of the first transistor.

According to the variable attenuator circuit of the present invention, since a signal input terminal (T3), a signal output terminal (T4) and one or a plurality of attenuation resistances (RQ2) series-connected to a signal line between these signal input and output terminals and whose at least one ends are electrically connected to second electrodes of first transistors, are provided in addition to the configuration of the variable resistor circuit according to the present invention, a variable attenuator circuit can be materialised which is capable of reducing variations in characteristic due to product variations and variations in temperature.

According to the variable gain amplifier of the present invention, since a variable attenuator according to the present invention and an amplifier provided at a stage preceding a signal input terminal of the variable attenuator for amplifying an ac signal, are provided, a variation in characteristic due to product variations and variations in temperature can be reduced or a desired smooth variable gain characteristic can be achieved.

Fig. 1

**Description**

This invention relates to variable resistor circuit, variable attenuators, a variable gain amplifier and a transistor circuit, which are suitable for use aboard a high-frequency semiconductor integrated circuit, for example.

As has been described in a technical literature "GaAs MESFET Circuit Design", pp.497-507, ARTECH HOUSE, INC., issued in 1988, ISDNO-89006-267-6, a variable resistor formed on a semiconductor integrated circuit is one of a type wherein a gate-to-source voltage VGS of a field-effect transistor (hereinafter abbreviated as "FET or transistor") is varied in a state in which a drain-to-source voltage of the field-effect transistor has been maintained substantially at 0V so as to vary a drain-to-source resistance RDS thereof.

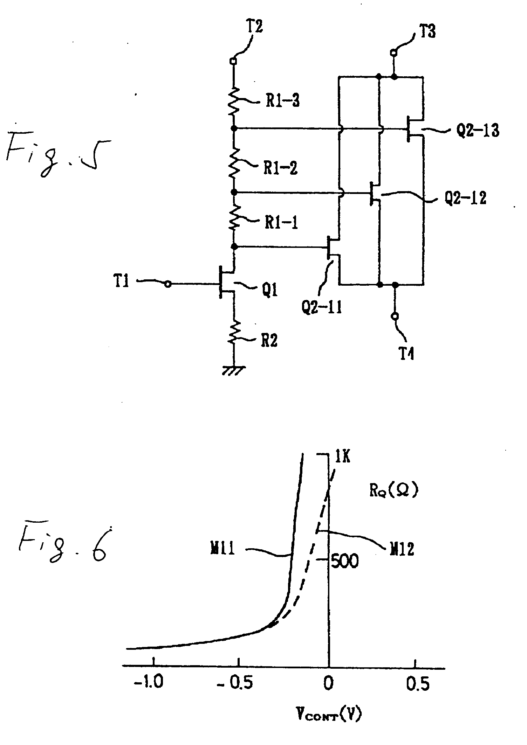

Fig. 2 is a characteristic curve diagram showing the manner of a change in drain-to-source resistance RDS with respect to the gate-to-source voltage VGS of the variable resistor referred to above. Incidentally, the difference in potential between the drain and source VDS is maintained substantially at 0V as described above.

When the gate-to-source voltage VGS is lower than a threshold voltage Vth in Fig. 2, the drain-to-source resistance RDS is in saturation. As the gate-to-source voltage VGS increases on the other hand, the drain-to-source resistance RDS is abruptly reduced with the threshold voltage Vth as a boundary. Thus, the drain-to-source resistance RDS can be used as a variable resistor in such a monotonously-decreased region.

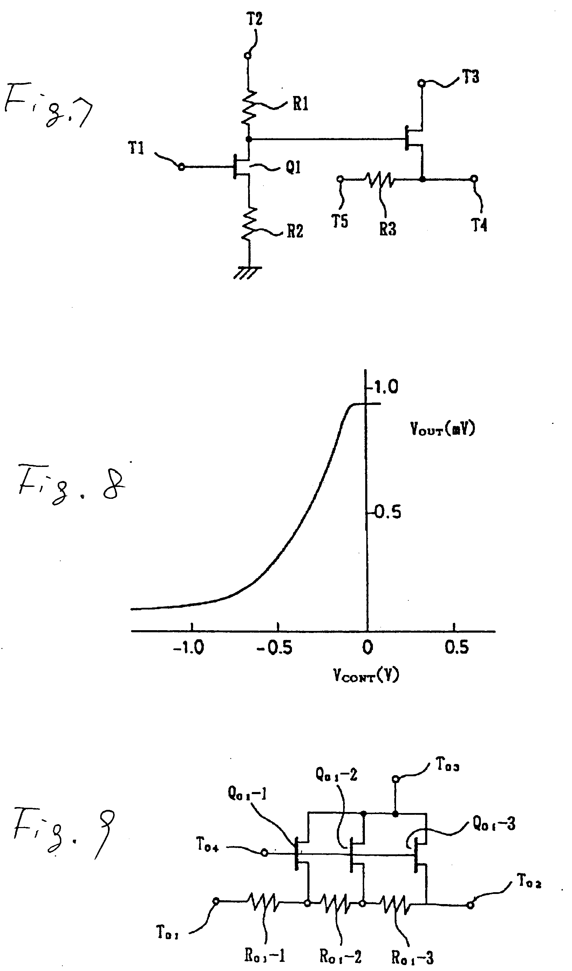

Fig. 3 is a circuit diagram showing a conventional variable attenuator. In Fig. 3, the conventional variable attenuator comprises a fixed resistance R01 interposed in a signal line between a signal input terminal T01 and a signal output terminal T02, and a transistor (FET) Q01 that constitutes the aforementioned variable resistor, for varying a resistance value according to a control voltage supplied from a terminal T04. Further, an ac signal input from the terminal T01, which is equal in dc level to a potential (e.g., 0V) at a terminal T03, is attenuated through a fraction of the input signal voltage by the transistor Q01 used as a variable resistance or resistor and the fixed resistance R01, followed by being output from the terminal T02.

According to a variable resistor of the present invention, since a control voltage amplifier, which amplifies an input control voltage and is composed of one or more transistors, and a first transistor used as a resistor, which has a control electrode supplied with the control voltage amplified by the control voltage amplifier and is set such that the value of a resistance between first and second electrodes thereof is varied according to the supplied control voltage, are provided, a variable resistor capable of compensating for product variations in characteristic of the first transistor used as the resistor and a variation in temperature of the first transistor can be materialized.

According to a variable attenuator of the present invention, since a signal input terminal, a signal output terminal and one or a plurality of attenuation resistances series-connected to a signal line between these signal input and output terminals and whose at least one ends are electrically connected to second electrodes of first transistors, are provided in addition to the configuration of the variable resistor according to the present invention, a variable attenuator can be materialized which is capable of reducing a variation in characteristic due to variations in product and a variation in temperature.

According to other variable attenuators of the present invention, since two or more resistances series-connected to a signal line between a signal input terminal and a signal output terminal and transistors used as variable resistor circuit, which respectively include second electrodes connected between these resistances or between the resistances and the signal input terminal without overlapping, first electrodes connected to ground and control electrodes each connected to a control terminal and which are identical in number to the resistances, are provided, a smooth control voltage vs. output voltage (attenuation) characteristic can be obtained as compared with the use of the single variable-resistance transistor. Further, the provision of these elements makes it easy to achieve a desired control voltage vs. output voltage characteristic owing to the selection of the values of the resistances.

According to a variable gain amplifier of the present invention, since a variable attenuator according to the present invention and an amplifier provided at a stage preceding a signal input terminal of the variable attenuator, for amplifying an ac signal, are provided, a variation in characteristic due to variations in product and a variation in temperature can be reduced or a desired smooth variable gain characteristic can be achieved.

According to a transistor circuit of the present invention, since electrode patterns of transistors that compensate for variations in characteristic and a variation in characteristic each other, are of identical shape with each other and disposed on a semiconductor chip so as to approach each other, the transistor circuit can provide sufficient compensation for the variation in characteristic of each transistor.

While the present invention has been described with reference to the illustrative embodiments, this description is not intended to be construed in a limiting sense. Various modifications of the illustrative embodiments, as well as other embodiments of the invention, will be apparent to those skilled in the art on reference to this description. It is therefore contemplated that the appended claims will cover any such modifications or embodiments as fall within the true scope of the invention.

While the specification concludes with claims particularly pointing out and distinctly claiming the subject matter which is regarded as the invention, it is believed that the invention, the objects, features and advantages thereof will be better understood from the following description taken in connection with the accompanying drawings in which:

Fig. 1 is a circuit diagram showing a first embodiment of a variable resistor;
Fig. 2 is a characteristic curve diagram used for describing problems of a conventional variable resistor;
Fig. 3 is a circuit diagram showing a conventional variable attenuator;
Fig. 4 is a characteristic curve diagram of the first embodiment shown in Fig. 1;
Fig. 5 is a circuit diagram showing a second embodiment of a variable resistor;
Fig. 6 is a characteristic curve diagram of the second embodiment shown in Fig. 5;
Fig. 7 is a circuit diagram illustrating a first embodiment of a variable attenuator;
Fig. 8 is a characteristic curve diagram of the first embodiment shown in Fig. 7;
Fig. 9 is a circuit diagram showing a second embodiment of a variable attenuator;
Fig. 10 is a circuit diagram illustrating a third embodiment of a variable attenuator;
Fig. 11 is a characteristic curve diagram of the third embodiment shown in Fig. 10;
Fig. 12 is a circuit diagram depicting an embodiment of a variable gain amplifier;
Fig. 13 is a circuit diagram showing a third embodiment of a variable resistor;
Fig. 14 is a characteristic curve diagram of the third embodiment shown in Fig. 13;
Fig. 15 is a circuit diagram depicting a fourth embodiment of a variable resistor;
Fig. 16 is a circuit diagram illustrating a fourth embodiment of a variable attenuator;
Fig. 17 is a circuit diagram showing a fifth embodiment of a variable attenuator;
Fig. 18 is a circuit diagram depicting a sixth embodiment of a variable attenuator;
Fig. 19 is a circuit diagram showing a seventh embodiment of a variable attenuator;
Fig. 20 is a circuit diagram illustrating an eighth embodiment of a variable attenuator;
Fig. 21 is a view showing the layout of electrode patterns employed in a fifth embodiment of a variable resistor; and
Fig. 22 is a view illustrating the layout of electrode patterns employed in a sixth embodiment of a variable resistor.

(A) First Embodiment of Variable Resistor:

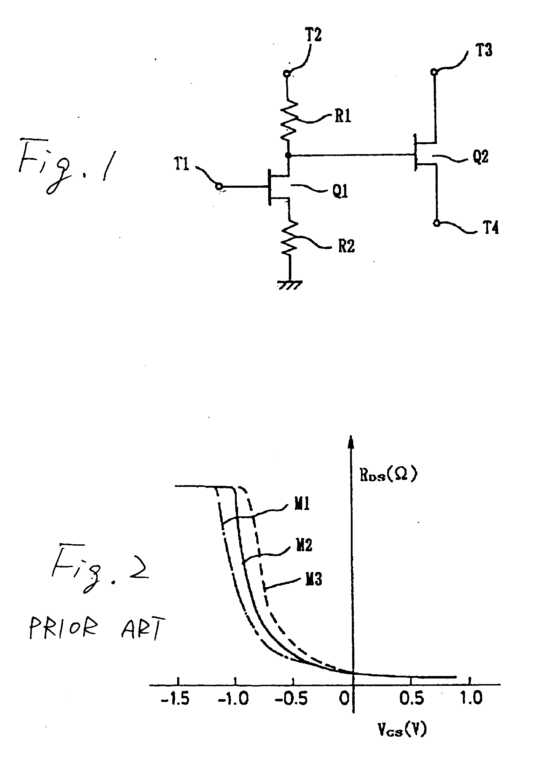

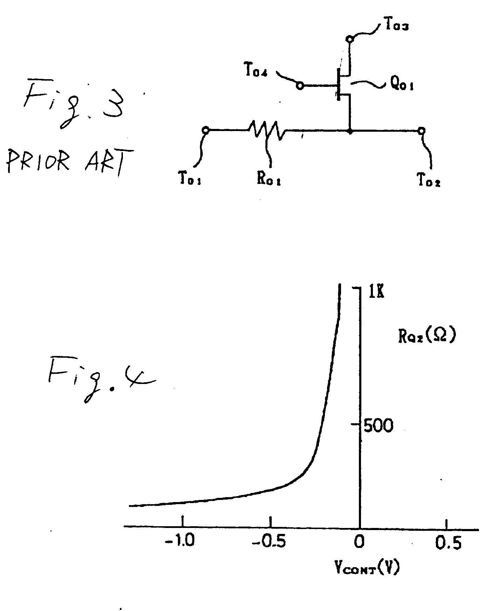

A first embodiment of a variable resistor according to the present invention will hereinafter be described in detail with reference to the accompanying drawings. Fig. 1 is a circuit diagram showing the variable resistor according to the first embodiment.

Referring to Fig. 1, a terminal T1 is supplied with a control voltage VCONT for controlling the value of a variable resistance. The terminal T1 is electrically connected to the gate of a transistor Q1. The transistor Q1 and a transistor Q2 to be described later are of depletion type MESFETs configured on a GaAs substrate, for example. The source of the transistor Q1 is electrically grounded through a self-bias resistance R2, whereas the drain thereof is electrically connected to a source voltage terminal T2 through a load resistance R1. Namely, the transistor Q1 functions as a common-source amplifier.

Further, the drain of the transistor Q1 is also electrically connected to the gate of the transistor Q2. The transistor Q2 behaves as a variable resistor and the drain and source of the transistor Q2 are electrically connected to terminals T3 and T4 respectively. In other words, when only the transistor Q2 is extracted from the circuit diagram shown in Fig. 1, the transistor Q2 is configured similarly to a conventional variable resistor. Therefore, the potential at the terminal T3 must be equal to that at the terminal T4 or must be held at a potential substantially identical to that at the terminal T4 so that a drain-to-source voltage VDS of the transistor Q2 becomes a substantially 0V. This is because the transistor Q2 becomes a resistor large in nonlinearity as the potential at the terminal T3 differs from that at the terminal T4 and is liable to cause distortion.

All the components that constitute the variable resistor according to the first embodiment, are integrated into the same semiconductor chip (e.g., GaAs chip).

In the variable resistor according to the first embodiment, the control voltage VCONT supplied through the control terminal T1 is amplified by the common-source amplifier composed principally of the transistor Q1, followed by application to the gate of the transistor Q2 without directly applying the control voltage VCONT to the gate of the transistor Q2 that constitutes the variable resistor, whereby a resistance (i.e., a drain-to-source resistance of the transistor Q2) RQ2 between the terminals T3 and T4 is varied.

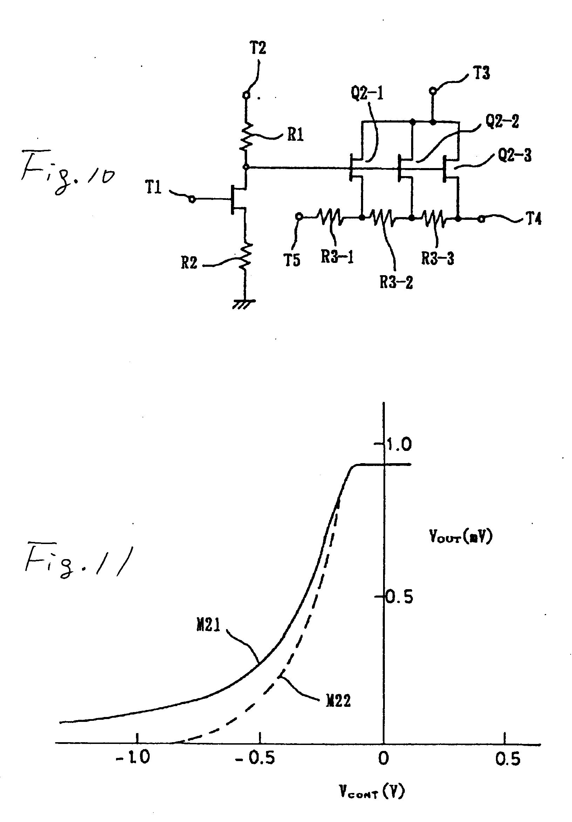

Fig. 4 is a characteristic curve diagram illustrating a VCONT vs. RQ2 characteristic (control voltage vs. resistance characteristic) of the variable resistor. Fig. 4 illustrates a characteristic obtained when the load resistance R1 is 1.3 kΩ, the self-bias resistance R2 is 1 kΩ, the mutual conductances of the transistors Q1 and Q2 are respectively 10 mS and 3 volts are applied across the terminals T2 and T3.

In Fig. 4, a control voltage VCONT lower than a potential (ground potential) at the source of the depletion type transistor Q1 is applied to the gate of the depletion type transistor Q1 and a drain potential amplified by the transistor Q1 is applied to the gate of the depletion type transistor Q2. Therefore, the resistance (i.e., the drain-to-source resistance of the transistor Q2) RQ2 between the terminals T3 and T4 monotonously increases as the control voltage VCONT increases in a negative range.

It can be considered that since both the transistors Q1 and Q2 are integrated on the same semiconductor chip, they have characteristics substantially identical to each other and threshold voltages Vth of both the transistors Q1 and Q2 are also the same.

Therefore, a variation developed in the threshold voltage Vth of the transistor Q2 upon production can be offset with the transistor Q1 by suitably selecting the values of the load resistance R1 and the self-bias resistance R2 as in the aforementioned examples. Assuming now that a deviation corresponding to a variation in designed value of the threshold voltage Vth on a variable resistor product is given by ΔVth, a voltage output from the common-source amplifier becomes a voltage deviate from the substantially designed value by about - ΔVth, followed by application to the gate of the transistor Q2, whereby this deviation is canceled by ΔVth corresponding to the variation in threshold voltage Vth of the transistor Q2.

Even if the threshold voltages Vth of the transistors Q1 and Q2 actually vary in the range of -0.5V to -1.5V in the variable resistor according to the first embodiment, the characteristic curve shown in Fig. 4 is little varied and is hence virtually superimposed on the same characteristic curve.

According to the variable resistor showing the first embodiment, as has been described above, the common-source amplifier is provided at a stage preceding the gate of the variable-resistance transistor (FET) to amplify the control voltage and the amplified voltage is applied to the gate of the variable-resistance transistor. Further, the variable-resistance transistor (FET) and the common-source amplifier are integrated onto the same semiconductor chip. Therefore, a variable resistor can be realized wherein a product variation in control voltage vs. resistance characteristic is low.

Even if the threshold voltage varies with a change in ambient temperature, a variable resistor free of a variation in control voltage vs. resistance characteristic can be materialized.

(B) Second Embodiment of Variable Resistor:

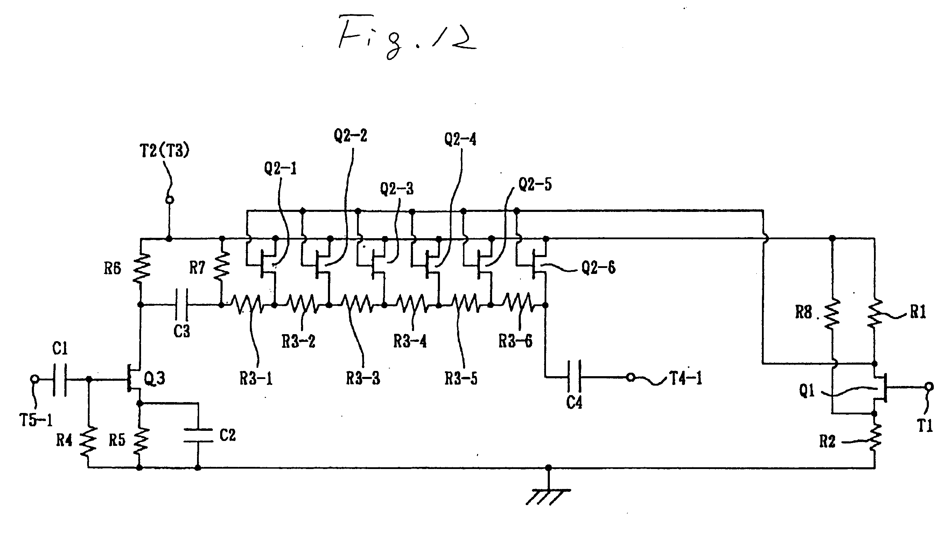

A second embodiment of a variable resistor according to the present invention will next be described in detail with reference to the accompanying drawings. Fig. 5 is a circuit diagram showing the variable resistor according to the second embodiment. The same elements of structure as those shown in Fig. 1 or elements corresponding to those shown in Fig. 1 are identified by like reference numerals or corresponding reference numerals.

In the variable resistor according to the second embodiment shown in Fig. 5, the load resistance R1 of the transistor Q1 employed in the first embodiment is divided into a plurality of resistances (three resistances R1-1 through R1-3 in the present embodiment), which are in turn connected in series. Further, variable-resistance transistors (FETs) Q2-11 through Q2-13 corresponding to the number of division of the load resistance are provided in parallel between terminals T3 and T4 as an alternative to the transistor Q2 employed in the first embodiment. The gates of the newly-provided transistors Q2-11, ..., Q2-13 are respectively supplied with different control voltages obtained under the functions of a group of the divided load resistances R1-1 through R1-3.

In the second embodiment, each of the values of the load resistances R1-1 through R1-3 is selected to a value (corresponding to about 430Ω if R1 is 1.3 kΩ) equal to one-third the value of the load resistance R1 employed in the first embodiment. Further, the widths of the gates of the transistors Q2-11, ..., Q2-13 are respectively selected to one-third the width of the gate of the transistor Q2 employed in the first embodiment, for example. Mutual conductances of the transistors Q2-11, ..., Q2-13 are respectively selected to one-third (about 3.3 mS) the mutual conductance of each transistor employed in the embodiment. Other parameters are all similar to those employed in the first embodiment.

The variable resistor according to the second embodiment is also identical in basic technical idea to that according to the first embodiment. Namely, the variable resistor according to the second embodiment is also constructed in the same manner as described above. A common-source amplifier is provided at a stage preceding the gates of the transistors Q2-11 through Q2-13 to amplify a control voltage. Next, the amplified voltage is applied to the gates of the transistors Q2-11 through Q2-13. Further, the transistors Q2-11 through Q2-13 and the common-source amplifier are integrated on the same semiconductor chip. Therefore, a variation in threshold voltage of each of the transistors Q2-11 through Q2-13 due to the product and temperature and a variation in threshold voltage of the transistor Q1 in the common-source amplifier due to the product and temperature are canceled each other so that a satisfactory control voltage vs. variable resistance characteristic can be obtained.

However, the difference in construction between the variable resistor circuit according to the first and second embodiments is made to increase the smoothness of a control voltage vs. variable resistance characteristic (VCONT vs. RQ characteristic) curve. Incidentally, the resistance between the terminals T3 and T4 is represented by RQ in the second embodiment.

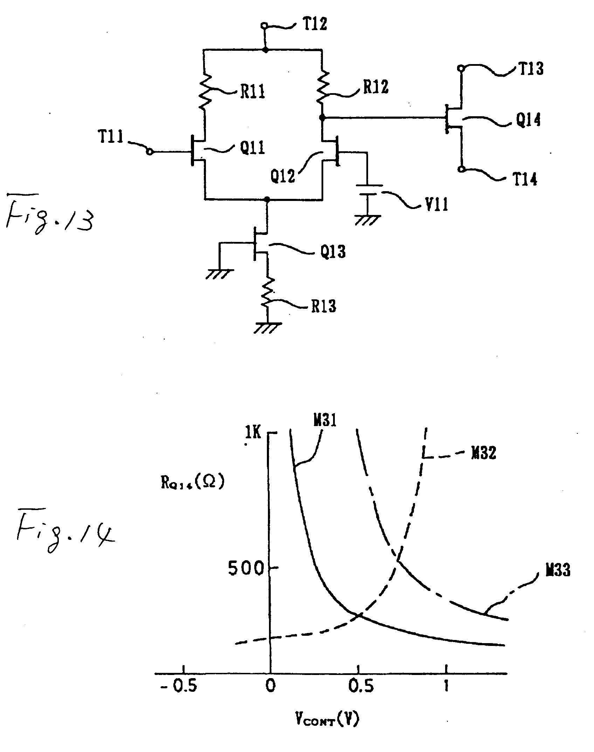

Fig. 6 illustrates the control voltage vs. variable resistance characteristic curve M11 (indicated by a solid line and identical to that shown in Fig. 4 but re-inserted) obtained in the first embodiment and a control voltage vs. variable resistance characteristic curve M12 (indicated by a broken line) obtained in the second embodiment. It is apparent from Fig. 6 that the characteristic curve M12 varies slowly as compared with the characteristic curve M11. This difference will result from the following reasons.

Namely, in the first embodiment, as the control voltage VCONT gradually increases from the negative voltage, the transistor (FET) Q2 is abruptly pinched off with a given voltage as the threshold so that the resistance RQ becomes great. In the second embodiment in contrast with the first embodiment, since the plurality of transistors (FETs) Q2-11 through Q2-13 are electrically connected in parallel and different gate voltages obtained by making fractions of the applied voltage with the plurality of load resistances R1-1 through R1-3 are applied to their corresponding transistors Q2-11 through Q2-13, the transistors Q2-11, ..., Q2-13 are respectively activated under control voltages different from each other. Therefore, the values of the input control voltages VCONT at which the transistors Q2-11, ..., Q2-13 are respectively pinched off, differ from each other and hence the varied shape of the characteristic curve M12 is eased. Since the resistance RQ between the terminals T3 and T4 is a resistance value of combination of drain-to-source resistances of the transistors Q2-11, ..., Q2-13 in parallel, the combined resistance value becomes smaller than the value of the drain-to-source resistance of each of the transistors Q2-11, ..., Q2-13. This also permits easing of the varied shape of the characteristic curve M12.

Thus, the variable resistor according to the second embodiment can bring about the following advantageous effects as well as those obtained in the first embodiment.

Namely, a load resistance of a common-source amplifier is divided into individual resistances. Voltages different from each other are respectively drawn from nodes among the divided resistances so as to be applied to the gates of a plurality of variable-resistance transistors (FETs). Therefore, a variable resistor having a control voltage vs. resistance characteristic which varies slowly, can be obtained.

Incidentally, the arbitrary selection of the number of division of the load resistance and the number of the transistors and the arbitrary selection of a voltage division ratio between the divided load resistances can provide a variable resistor having a control voltage vs. resistance characteristic which exhibits an arbitrary varied shape.

(C) First Embodiment of Variable Attenuator:

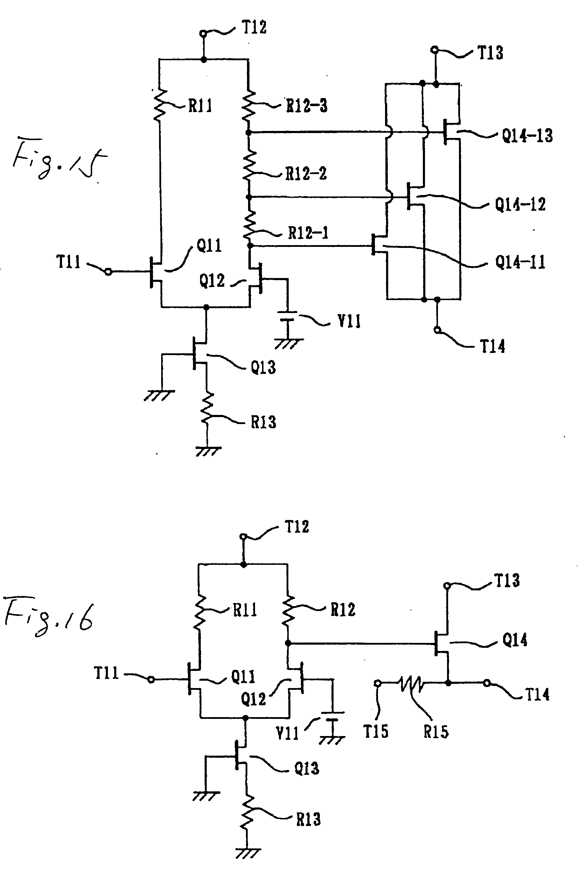

A first embodiment of a variable attenuator according to the present invention will next be described in detail with reference to the accompanying drawings. Fig. 7 is a circuit diagram showing the variable attenuator according to the first embodiment. The same or corresponding elements of structure as those shown in Fig. 1 are identified by like reference numerals.

The variable attenuator showing the first embodiment is configured using the variable resistor of the first embodiment shown in Fig. 1. As is apparent from the comparison between Figs. 7 and 1, the present variable attenuator is provided with an additional input terminal T5 and a resistance R3 inserted between terminals T4 and T5 in addition to the configuration shown in Fig. 1.

The variable attenuator is based on the conventional idea (refer to Fig. 3) that the variable attenuator is constructed using the variable resistor.

Namely, the level of an ac signal input through the terminal T5, which is equal in dc level to a potential (e.g., 3V) at a terminal T3, is attenuated through a fraction of the applied signal voltage by a fixed resistance R3 interposed in a signal line between the signal input terminal T5 supplied with the ac signal and a signal output terminal T4 and a transistor (FET) Q2 whose resistance value (corresponding to a drain-to-source resistance value) is varied, after which the attenuated voltage level is output through the terminal T4.

When only an ac component contained in the ac signal, which is raised by a level equal to the dc level at the terminal T3 (if the dc level is 0V, its rise operation is unnecessary) after the ac signal has passed through a dc blocking capacitor, an ac signal having an effective value of 1 mV and a frequency of 100 MHz, for example, is input to the terminal T5. The attenuated signal output from the signal output terminal T4 is sent to a processing circuit corresponding to the next stage via an unillustrated dc blocking capacitor, for example. The amplitude of the input signal is selected to the effective value of about 1 mV in consideration of the condition that the difference in potential between the drain and source of the transistor Q2 is set to about 0V as the premise that the transistor Q2 is used as a variable resistor.

The variable resistor according to the first embodiment shows the case where that the terminal T3 is electrically connected to the dc power similar to that connected to the terminal T2 as described above. It is preferable that even when the terminal T3 is connected to the same dc power in this way, a capacitor (not shown) is connected between the terminal T3 and ground so that the terminal T3 is grounded on an ac basis, thereby preventing the terminal T3 from being affected by the ac signal input from the terminal T5.

Further, the value of the fixed resistance R3 is determined from a tie with desired attenuation. It is however necessary to define the value of the fixed resistance R3 so that it satisfies even the condition that the difference in potential between the drain and source of the transistor Q2 is set to about 0V as the premise that the transistor Q2 is used as the variable resistor. When the resistance RQ2 between the drain and source of the transistor Q2 takes a variable range (of 1 kΩ or so at maximum) as shown in Fig. 4, the value of the fixed resistance R3 is selected to about 1 kΩ. Further, even if the difference in potential between the drain and source of the transistor Q2 varies due to a voltage divide-by-resistance operation made to the ac signal input, the aforementioned premise will be regarded as being satisfied.

It is further desirable that in order to stably maintain the potentials at the terminals T4 and T5 at the same potential as that at the terminal T3, a resistance (not shown; for example, 10 kΩ) whose resistance value is so larger than the variable resistance range of the transistor Q2, is electrically connected between the terminals T3 and T4 so as to prevent the resistance value of the transistor Q2 from varying due to a variation in ac signal.

Other parameters are selected to such values as described in the first embodiment of the variable resistor, for example.

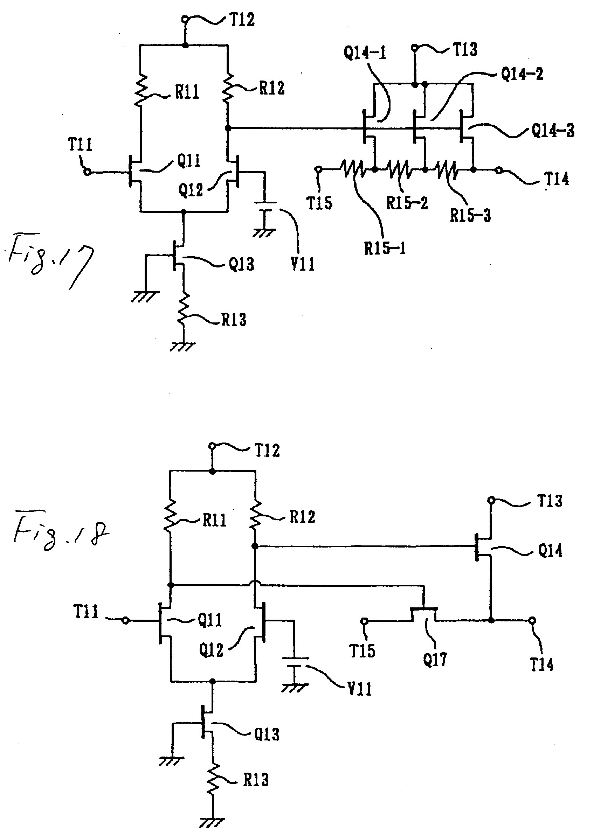

Fig. 8 is a characteristic curve diagram showing a control voltage vs. output voltage characteristic obtained in the first embodiment of the variable attenuator. Namely, Fig. 8 shows the manner in which a voltage (effective value) VOUT output from the terminal T4 varies with a change in control voltage VCONT applied to a terminal T1. It is understood from Fig. 8 that the variable attenuator is configured wherein even if the input signal level is the same, its attenuation (output voltage) varies with the change in control voltage VCONT.

Since the components of the variable attenuator are integrated on the same semiconductor chip, a variation in threshold voltage Vth of the transistor (FET) Q2 used as the variable resistor and a variation in threshold voltage in a pre-stage common-source amplifier are canceled each other as described in the variable resistor according to the first embodiment. Thus, even if the threshold voltages Vth of the transistors Q1 and Q2 vary in the range of -0.5V to -1.5V, the characteristic curve illustrated in Fig. 8 is little affected by their variations.

According to the variable attenuator showing the first embodiment, as has been described above, since the resistance R3 is provided on the source side of the transistor Q2 of the variable resistor according to the first embodiment, a variable attenuator can be materialized wherein a product variation in control voltage vs. output voltage (attenuation) characteristic is small.

Even if an ambient temperature varies, a variable attenuator no causing a variation in control voltage vs. output voltage (attenuation) characteristic can be materialized.

(D) Second Embodiment of Variable Attenuator:

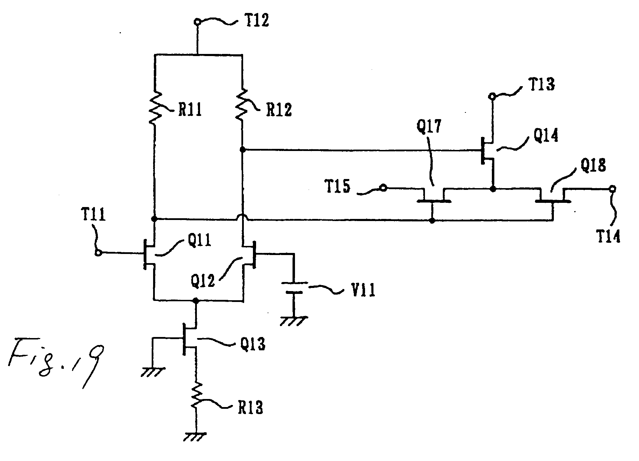

A detailed description will now be made of a second embodiment of a variable attenuator according to the present invention with reference to the accompanying drawings. Fig. 9 is a circuit diagram showing the variable attenuator according to the second embodiment. The same or corresponding elements of structures as those shown in Fig. 3 illustrative of the conventional example referred to above are identified by like reference numerals.

Referring to Fig. 9, the variable attenuator according to the second embodiment also includes an ac signal input terminal T01, a signal output terminal T02, a terminal T03 connected to ac-ground, and a terminal T4 for controlling attenuation in a manner similar to the conventional variable attenuator (see Fig. 3).

In the variable attenuator according to the second embodiment, however, the fixed resistance R01 employed in the conventional example is divided into a plurality of fixed resistances (three resistances R01-1, R01-2 and R01-3 in Fig. 9) so that its resistance value is divided into equal resistance values, for example, whereby ladder resistances are formed. Further, the transistor (FET) serving as the variable resistor, which has been provided by one in the conventional example, is provided by the number equal to the number of division of the fixed resistance. The drains of the so-provided transistors Q01-1, Q01-2 and Q01-3 are commonly connected to the terminal T03, the gates thereof are commonly connected to the terminal T04 and the sources thereof are connected to their corresponding different nodes (divided points) of the ladder resistances. A characteristic of each of the transistors Q01-1, Q01-2 and Q01-3 is selected so that the circuit of parallel-connected transistors Q01-1, Q01-2 and Q01-3 becomes equivalent to the conventional one transistor Q01.

It is always necessary to maintain dc potentials at the terminals T01 and T02 so as to become as equal as possible to a potential at the terminal T3. This is because the more the potentials differ from each other, the more a signal output from the terminal T02 is distorted.

When the terminal T03 is connected to ground, for example, an ac signal whose dc level is set to 0V and whose amplitude is small, is input to the terminal T01 via a dc blocking capacitor. Further, an ac signal is output from the terminal T02 to the next-stage processing circuit via a dc blocking capacitor not so as to be affected by a dc level on the processing circuit side. Further, in order to maintain the potentials at the terminals T01 and T02 at the ground potential identical to that at the terminal T03, a resistance whose value is sufficiently larger than the values of the resistances R01-1, R01-2 and R01-3 and so smaller than source-to-drain resistances of the transistors Q01-1, Q01-2 and Q01-3 at their pinch-off, is electrically connected between the terminals T03 and T02.

An attenuation operation and attenuation of the conventional variable attenuator shown in Fig. 3 will now be discussed.

An ac signal input from the terminal T01 is subjected to voltage division by the transistor Q01 used as the variable resistor and the fixed resistance R01, followed by output through the terminal T02. Let's now assume that the fixed resistance R01 is 1 k$\Omega$ and a drain-to-source resistance RQ01 of the transistor Q01 is 100 $\Omega$. In this case, the signal VIN input to the terminal T01 reaches 9.1% in accordance with the following equation (1), which is in turn output from the terminal T02.

$$VOUT = RQ01 \times VIN/(R01 + RQ01) \qquad (1)$$

An attenuation operation and attenuation of the variable attenuator according to the second embodiment will next be discussed.

Now consider that the values of the fixed resistances R01-1, R01-2 and R01-3 are respectively 333 Ω (because the resistance R01 shown in Fig. 3 is divided into the three equal parts) and a control voltage Vc same as that employed in the conventional circuit is applied to the transistors Q01-1, Q01-2 and Q01-3. If the drain-to-source resistances of the transistors Q01-1, Q01-2 and Q01-3 are set so as to become equivalent to those obtained by dividing the drain-to-source resistance of the transistor Q01 shown in Fig. 3 into the three equal parts, then the drain-to-source resistances are respectively 300 Ω. If the signal VIN supplied to the terminal T01 at this time is calculated using the Kirchhoff's laws although their detailed computational equation is omitted, it reaches 6.6%, which is in turn output from the terminal T02.

Namely, even if the values of the fixed resistances inserted in a signal line in series are the same, the present variable attenuator can obtain greater attenuation as compared with the conventional variable attenuator.

Losses produced when the signal input from the terminal T01 is output without attenuation, will next be discussed.

Assuming now that the value of the fixed resistance R01 is 1 kΩ in the same manner as described above and the drain-to-source resistance RQ01 of the transistor Q01 is 10 kΩ with respect to an arbitrary control voltage Vc applied to the terminal T04 in the conventional variable attenuator shown in Fig. 3, 90.9% of the signal VIN input to the terminal T01 is output from the terminal T02 although its computational expression is omitted.

Now consider that the values of the fixed resistances R01-1, R01-2 and R01-3 are respectively 333 Ω and the values of the drain-to-source resistances of the transistors Q01-1, Q01-2 and Q01-3 are respectively 30 kΩ in the variable attenuator according to the second embodiment. In this case, the input signal VIN reaches 93.7%, which is in turn output from the terminal T02.

Namely, even if the values of the resistances inserted into the signal line in series are the same, the signal can be transmitted with less loss.

According to the variable attenuator showing the second embodiment, as has been described above, the transistor (FET) activated as the variable resistor is divided into the plural portions, which are in turn connected in parallel. Further, the resistance interposed in the signal line is also divided into the numbers identical to the number of the divided transistors and the divided resistances are connected between the sources of the divided transistors. Therefore, the variable attenuator can be materialized which eliminates an increase in resistance value on the signal line, increases an attenuation variable range and provides less insertion loss (upon the minimum attenuation).

Since each resistance on the signal line can be lowered if it is desired to obtain the attenuation variable range substantially identical to the conventional one, the generation of noise can be curbed and a transmission characteristic can be prevented from varying due to the frequency even if capacitive or inductive loads exist in input and output portions.

(E) Third Embodiment of Variable Attenuator:

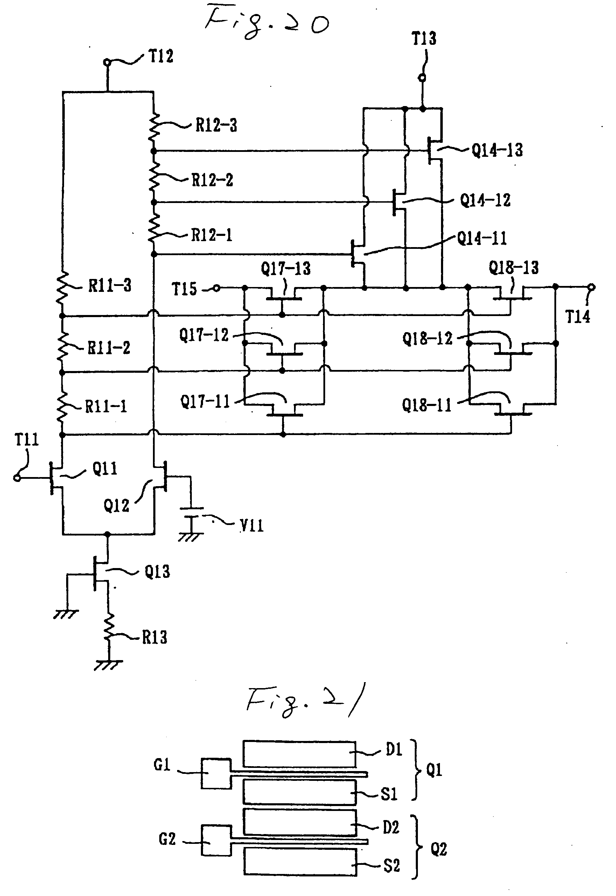

A third embodiment of a variable attenuator according to the present invention will next be described in detail with reference to the accompanying drawings. Fig. 10 is a circuit diagram showing the variable attenuator according to the third embodiment. The same or corresponding elements of structure as those shown in Fig. 7 are identified by the same reference numerals.

As is apparent from the comparison between Fig. 10 and Figs. 7 and 9, the variable attenuator according to the third embodiment is one obtained by introducing the technical idea of the variable attenuator according to the second embodiment into the variable attenuator according to the first embodiment.

Namely, the transistor (FET) Q2 activated as the variable resistor in the first embodiment is divided into a plurality of transistors (three transistors Q2-1 through Q2-3 here), which are in turn connected in parallel. Further, the fixed resistance R3 interposed in the signal line extending from the terminal T5 to the terminal T4 is also divided into resistors R3-1 through R3-3 corresponding to the same numbers as described above, which are in turn connected between the sources of the divided variable-resistance transistors Q2-1, ..., Q2-3.

Thus, if the value of the resistance R3 is 1 kΩ, then the values of the respective resistances R3-1, ..., R3-3 are respectively 333 Ω. If the mutual conductance of the transistor Q2 is 10 mS, then the mutual conductances of the transistors Q2-1, ..., Q2-3 become 3.3 mS respectively.

A common-source amplifier for outputting a voltage to the gates of the transistors Q2-1, ..., Q2-3 is identical in structure to that employed in the first embodiment.

Fig. 11 shows the control voltage vs. output voltage characteristic curve M21 (indicated by the solid line and identical to that shown in Fig. 8 but re-described) of the variable attenuator according to the first embodiment and a control voltage vs. output voltage characteristic curve M22 (indicated by a broken line) obtained in the variable attenuator according to the third embodiment.

It is apparent from Fig. 11 that if the characteristic curve M22 according to the third embodiment is compared with the characteristic curve M21 according to the first embodiment, an output voltage VOUT becomes small in a region in which a control voltage VCONT is low. In other words, it is understood that large attenuation can be obtained. The difference in characteristic referred to above occurs due to the difference in attenuation operation and attenuation between the variable attenuator according to the second embodiment and the conventional variable attenuator as described above.

Accordingly, the variable attenuator according to the third embodiment can bring about both the advantageous effects obtained by the variable attenuators according to the first and second embodiments.

Namely, a variable attenuator can be provided wherein a product variation in control voltage vs. output voltage (attenuation) characteristic is small and even if an ambient temperature varies, the control voltage vs. output voltage (attenuation) characteristic remains unchanged. Further, a variable attenuator can be provided which avoids an increase in resistance value on the signal line, increases an attenuation variable range and provides less insertion loss (upon the minimum attenuation). Since each resistance on the signal line can be lowered if it is desired to obtain the attenuation variable range substantially identical to the conventional one, the generation of noise can be curbed and a transmission characteristic can be prevented from varying due to the frequency.

(F) Embodiment of Variable Gain Amplifier:

An embodiment of a variable gain amplifier according to the present invention will next be described in detail with reference to the accompanying drawings. Fig. 12 is a circuit diagram showing the variable gain amplifier according to the present embodiment. The same or corresponding elements of structure as those shown in Fig. 10 are identified by the same or corresponding reference numerals.

The variable gain amplifier according to the present embodiment is constructed such that a common-source amplifier configuration is provided on the signal input side of the variable attenuator configuration according to the third embodiment.

Accordingly, the variable gain amplifier includes the configuration of the variable attenuator according to the third embodiment as it is. Namely, the variable gain amplifier according to the present embodiment comprises a common-source amplifier configuration (Q1, R1 and R2) for amplifying a control voltage VCONT input from a terminal T1, a plurality of transistors (FETs) (six transistors Q2-1 through Q2-6 in the drawing) activated as variable resistor circuit, and a plurality of fixed resistances (six resistances R3-1 through R3-6) respectively connected between the adjacent transistors.

Incidentally, a resistance R8 unillustrated in Fig. 10, which is provided as an element for the common-source amplifier used to amplify the control voltage VCONT, is of a resistance for allowing a constant current to flow through the self-bias resistance R2. This resistance also serves so as to bias a source potential of the transistor Q1 in a plus direction. Namely, even if the transistor Q1 is of a depletion type FET, only a positive voltage is applied to the terminal T1 so as to allow the control of the variable gain amplifier.

A capacitor C4 for blocking a dc component of a signal attenuated through the above-described variable attenuator is also shown in Fig. 12. An output signal whose dc component has been blocked is output from a terminal T4-1.

An amplifier configuration for amplifying an input signal, which is provided inclusive of a configuration similar to the aforementioned variable attenuator according to the third embodiment, will next be described.

A transistor (FET) Q3 performs an amplifying operation and an ac signal (high-frequency signal) input from a terminal T5-1 becomes only an ac component through a capacitor C1, followed by inputting to the gate of the transistor Q3.

A resistance R4 having a high resistance value for fixing a gate bias potential to the ground potential is electrically connected between the gate of the transistor Q3 and ground (GND). Further, the source of the transistor Q3 is grounded via a parallel circuit composed of a self-bias resistance R5 and a capacitor C2 for grounding the source of the transistor Q3 on a high-frequency basis. Furthermore, the drain of the transistor Q3 is electrically connected to a source voltage terminal T2 (T3) through a load resistance R6.

An amplified signal output from the drain of the transistor Q3 is supplied to the variable attenuator side through an ac coupling capacitor (dc blocking capacitor) C3. A resistance R7 having a high resistance value, which is electrically connected between an input point (corresponding to an output point of the capacitor C3) on the variable attenuator side and the source voltage terminal T2 (T3), is used to maintain a potential on a signal line extending from the output point of the capacitor C3 to an input point of the capacitor C4 at a potential applied to the source voltage terminal T2 (T3). In other words, the resistance R7 is used to bring the difference in potential between the drain and source of each of the transistors Q2-1 through Q2-6 each activated as the variable resistor into about 0V.

A positive dc voltage is applied to the source voltage terminal T2 (T3) but grounded on a high-frequency basis. It is preferable to configure all the components on the same semiconductor chip. It is particularly necessary to form the transistors (FETs) Q1 and Q2-1 through Q2-6 corresponding to the components of the variable attenuator under the same process and condition.

In the illustrated variable gain amplifier, the input ac signal is amplified at fixed gain by the common-source amplifier composed principally of the transistor Q3, followed by inputting to the variable attenuator. Further, the amplified signal is attenuated by the variable attenuator for varying an attenuation characteristic according to the control voltage input to the terminal T1, so that the gain of an output signal with respect to the input signal is varied.

According to the variable gain amplifier of the present embodiment, since the amplifier provided at the input stage and the variable attenuator capable of providing a wide attenuation characteristic variable range are connected to each other, a large gain variable range can be obtained.

Since the variable attenuator according to the third embodiment capable of exhibiting the aforementioned advantageous effects is used, a variable gain amplifier can be materialized which has low-noise, low power consumption and low-distortion characteristics resistant to the influence of a variation in control voltage vs. gain characteristic due to variations of production of transistors (FETs) and temperatures.

Further, since the sources and drains of the transistors Q2-1 through Q2-6 are set to the source potential and the source of the transistor Q1 is biased through the resistance R8, the gain can be controlled under a potential identical in sign or polarity to the source potential (for example, under a plus voltage if the power is plus).

(G) Third Embodiment of Variable Resistor:

A third embodiment of a variable resistor according to the present invention will next be described in detail with reference to the accompanying drawings. Fig. 13 is a circuit diagram showing the variable resistor according to the third embodiment.

In the variable resistor according to the first embodiment shown in Fig. 1, the common-source amplifier is electrically connected to the variable-resistance transistor to cancel the variation in threshold voltage due of the transistor (FET) due to the product and the ambient temperature. The variable resistor according to the third embodiment also makes use of a technical idea similar to the above. However, the present variable resistor is different from that according to the first embodiment in that a single-ended differential amplifier is used as an alternative to the amplifier for canceling the variation in threshold voltage of the transistor (FET) due to the product and the ambient temperature.

Referring to Fig. 13, a transistor Q14 whose drain and source are respectively electrically connected to terminals T13 and T14 and substantially identical in potential to each other, is of a variable-resistance transistor. Further, the gate of the transistor Q14 is electrically connected to an output terminal of the differential amplifier which will be described later.

The single-ended differential amplifier is configured such that a pair of transistors Q11 and Q12 is of a transistor pair for amplifying the difference between two inputs signals and the gate of one transistor Q11 is electrically connected to an input terminal T11 supplied with a control voltage VCONT, whereas the gate of the other transistor Q12 is electrically connected to a bias supply V11. The drains of these transistors Q11 and Q12 are electrically connected via their corresponding load resistances R11 and R12 to a source voltage terminal T12. Further, the sources of the transistors Q11 and Q12 are commonly connected to the drain of a transistor Q13 which serves as a current source for the differential amplifier. The gate of the transistor Q13 is grounded and the source thereof is grounded via a self-bias resistance R13.

Further, the drain of the transistor Q12 is electrically connected to the gate of the transistor Q14.

Incidentally, a depletion type MESFET formed on a GaAs substrate, for example, is used as each of the transistors Q11, ..., Q14. Further, all the components of the corresponding variable resistor are formed on the same semiconductor chip (e.g., GaAs chip).

Thus, even in the case of the variable resistor according to the third embodiment, the control voltage VCONT applied to the terminal T11 is amplified and the amplified voltage is applied to the gate of the variable-resistance transistor Q14 so that a resistance RQ14 (i.e., a drain-to-source resistance of the transistor Q14) between the terminals T13 and T14 set so as to be substantially identical in potential to each other, is varied.

Selected examples of the values of the respective circuit elements will now be described as follows: The values of the load resistances R11 and R12 are both set to 1 kΩ and the value of the self-bias resistance R13 is set to 200 Ω. Further, the mutual conductance of each of the transistors Q11 through Q13 is set to 1 mS and the gate of the transistor Q12 is supplied with a dc bias voltage of 0.5V. Furthermore, the mutual conductance of the transistor Q14 is set to 10 mS and the potential at the terminal T13 is set to 3V identical to that applied to the terminal T21.

Fig. 14 is a characteristic curve diagram showing a control voltage vs. resistance characteristic obtained by the variable resistor according to the third embodiment.

A characteristic curve M31 indicated by a solid line is obtained when the values of the circuit elements are selected as described above. As the control voltage VCONT increases in a positive range, the resistance RQ14 decreases monotonously.

Since the transistors Q11 through Q14 are integrated on the same semiconductor chip, they have characteristics substantially identical to each other. Namely, the threshold voltages Vth of the transistors Q11 and Q14 can be considered to be the same. Therefore, the application of suitable resistance values to the resistances R11 through R13 makes it possible to cancel a production variation in threshold voltage Vth of the transistor Q14 with the differential amplifier formed inclusive of the transistors Q11 through Q13.

Namely, even if the threshold voltage Vth varies in a range of -0.5V to -1.5V, the characteristic curve M31 shown in Fig. 14 remains little changed and is superimposed on the same curve.

Fig. 13 shows the case where the drain output of the transistor Q12 is electrically connected to the gate of the variable-resistance transistor Q14. However, the drain of the other transistor Q11 that constitutes the differential amplifying pair, may be connected to the gate of the variable-resistance transistor Q14. A control voltage vs. resistance characteristic obtained in this case becomes a characteristic curve M32 indicated by a broken line in Fig. 14. In the characteristic curve M32, the resistance RQ14 increases monotonously as the control voltage VCONT is increased.

Namely, the polarity of the control voltage vs. resistance characteristic can be freely selected by the choice of either of the transistors that constitute the differential amplifying pair one of which has the drain connected to the gate of the variable-resistance transistor Q14. The resistance value is controlled by the minus control voltage in the first embodiment (refer to Fig. 4), whereas in the fifth embodiment, the resistance RQ14 can be controlled by the positive control voltage VCONT as shown in Fig. 14.

The aforementioned characteristic curve M31 shown in Fig. 14 shows the case where the bias voltage applied to the transistor Q12 is 0.5V. When, however, the bias voltage is changed from 0.5V to 1V, a characteristic curve obtained at this time is given as a curve M33 indicated by a dashed line. Namely, the control voltage vs. resistance characteristic can be arbitrarily shifted by varying the bias voltage applied to the gate of the transistor Q12 without the changing of other parameters.

According to the variable resistor showing the third embodiment, as has been described above, since the differential amplifier is provided at the stage preceding the gate of the variable-resistance transistor so as to be integrated on the same semiconductor chip, a variable resistor can be materialized which provides less product variation in control voltage vs. resistance characteristic.

Even if an ambient temperature varies, a variable resistor can be realized which is free from a variation in control voltage vs. resistance characteristic.

It is also possible to provide the ease of arbitrarily setting the polarity of the voltage vs. resistance characteristic and arbitrarily shifting the control voltage vs. resistance characteristic curve through the selection of one transistor from the differential amplifying pair for taking out the amplified control voltage and the change in bias fixed to one transistor of the differential amplifying pair.

(H) Fourth Embodiment of Variable Resistor:

Fig. 15 is a circuit diagram showing a fourth embodiment of a variable resistor according to the present invention. The same or corresponding elements of structure as those in Fig. 13 are identified by like or corresponding reference numerals.

The variable resistor according to the fourth embodiment is equivalent to one obtained by introducing the technical idea of the variable resistor according to the second embodiment into the technical idea of the variable resistor according to the third embodiment.

Namely, the variable resistor according to the fourth embodiment is constructed as follows: The load resistance R12 for the transistor Q12 employed in the third embodiment is divided into a plurality of resistances (three resistances R12-1 through R12-3 in the present embodiment), which are in turn connected in series. Further, variable-resistance transistors Q14-11 through Q14-13 corresponding to the number of division of the load resistance are parallel-provided between terminals T13 and T14 as an alternative to the variable-resistance transistor Q14 employed in the third embodiment. The gates of the newly-provided variable-resistance transistors Q14-11, ..., Q14-13 are respectively supplied with different voltages obtained by the functions of a group of the divided load resistances R12-1 through R12-3.

Accordingly, the operation of the fourth embodiment as a differential amplifier is identical to that of the third embodiment. The operation of the fourth embodiment under which the total or composite resistance of the variable-resistance transistors Q14-11 through Q14-13 varies according to the amplified different control voltages, is identical to that of the second embodiment.

As a result, the variable resistor according to the fourth embodiment can bring about both advantageous effects obtained by the variable resistor circuit according to the first and second embodiments.

(I) Fourth Embodiment of Variable Attenuator:

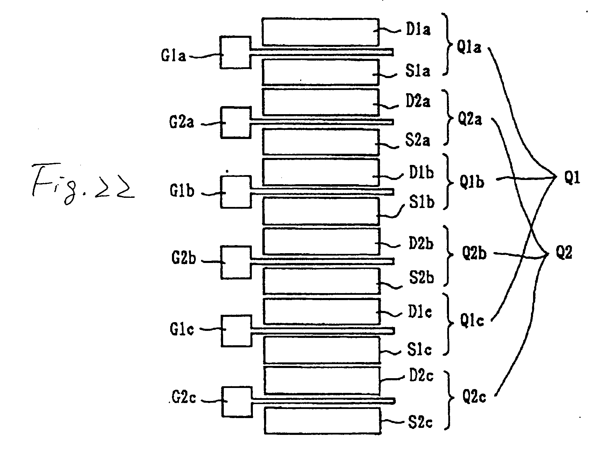

Fig. 16 is a circuit diagram showing a fourth embodiment of a variable attenuator according to the present invention. The same or corresponding elements of structure as shown in Fig. 13 are identified by like reference numerals.

The variable attenuator according to the fourth embodiment is formed by adding a fixed resistance R15, a signal input terminal T15 and a signal output terminal T14 to the configuration of the variable resistor according to the third embodiment shown in Fig. 13. Namely, the source of a variable-resistance transistor Q14 and the signal input terminal T15 are connected across the fixed resistance R15. Further, a potential applied to the source of the variable-resistance transistor Q14 is taken out from the signal output terminal T14.

Since the variable attenuator according to the fourth embodiment is identical in operation and effect to the variable resistor according to the third embodiment shown in Fig. 13 and the variable attenuator according to the first embodiment, their description will be omitted.

(J) Fifth Embodiment of Variable Attenuator:

Fig. 17 is a circuit diagram illustrating a fifth embodiment of a variable attenuator according to the present invention. The same or corresponding elements of structure as those shown in Fig. 16 are identified by the same or corresponding reference numerals.

The variable attenuator according to the fifth embodiment is equivalent to one obtained by introducing the technical idea of the variable attenuator according to the second embodiment into the technical idea of the variable attenuator according to the fourth embodiment shown in Fig. 16.

Namely, the variable attenuator is constructed as follows: The transistor (FET) Q14 activated as the variable resistor in the fourth embodiment is divided into a plurality of transistors (three transistors Q14-1 through Q14-3 in the present embodiment), which are in turn connected in parallel. Further, the fixed resistance R15 provided in the signal line extending from the terminals T15 to T14 is also divided into resistances R15-1 through R15-3 corresponding to the number the same as the number of the divided transistors. The divided resistances R15-1 through R15-3 are respectively connected between the sources of the variable-resistance transistors Q14-1, ..., Q14-3.

Since the variable attenuator according to the fifth embodiment is identical in operation and effect to the variable attenuator according to the fourth embodiment shown in Fig. 16 and the variable attenuator according to the second embodiment shown in Fig. 9, their description will be omitted.

(K) Sixth Embodiment of Variable Attenuator:

A sixth embodiment of a variable attenuator according to the present invention will next be described in detail with reference to the accompanying drawings. Fig. 18 is a circuit diagram showing the variable attenuator according to the sixth embodiment. The same or corresponding elements of structure as those shown in Fig. 16 are identified by like or corresponding reference numerals.

In the variable attenuator according to the sixth embodiment as is apparent from the comparison between Figs. 18 and 16, a transistor Q17 activated as a variable resistor is interposed in a signal line as an alternative to the attenuating fixed resistance R15 employed in the variable attenuator according to the fourth embodiment. An amplified control voltage obtained from the drain of a transistor Q11 is applied to the gate of the variable-resistance transistor Q17.

Namely, the values of resistances of the two variable-resistance transistors Q17 and Q14 can be simultaneously controlled by a control voltage VCONT applied to a terminal T14.

Even in the present embodiment, an ac signal is input to a signal input terminal T15 through a dc blocking capacitor and a signal is output from the signal output terminal T14 through a dc blocking capacitor. Even if the fixed resistance R15 is replaced by the transistor Q17, it is necessary to maintain potentials at the terminals T15 and T14 as equal as possible to a potential at a terminal T13.

Owing to the operation of a differential amplifier relative to a control voltage VCONT applied to a terminal T11, an amplified control voltage opposite in phase to the control voltage VCONT is applied to the gate of one variable-resistance transistor Q17, whereas an amplified control voltage which is in phase with the control voltage VCONT, is applied to the gate of the other variable-resistance transistor Q14.

Thus, as the control voltage VCONT applied to the terminal T11 increases, a drain-to-source resistance of one variable-resistance transistor Q17 becomes great, whereas a drain-to-source resistance of the other variable-resistance transistor Q14 becomes small (see Fig. 14).

When the level of a signal output from the signal output terminal T14, which is obtained by attenuating the input ac signal under the operation of voltage division of the two variable-resistance transistors Q14 and Q17, is maximized, the source-to-drain resistance of the transistor Q17 and the drain-to-source resistance of the transistor Q14 may be set so as to be as small and large as possible respectively. On the other hand, when the level of the signal output from the signal output terminal T14 is minimized, the source-to-drain resistance of the transistor Q17 and the drain-to-source resistance of the transistor Q14 may be set so as to be as large and small as possible respectively.

Since the resistance values of both the transistors Q14 and Q17 vary complementarily as described above, they are able to easily cope with the control on the level of the output signal.

Since product variations in threshold voltages Vth of the transistors Q14 and Q17 are also canceled by the differential amplifier provided at the stage preceding the transistors Q14 and Q17, a control voltage vs. output voltage (attenuation) capable of providing less variations can be obtained.

According to the variable attenuator showing the sixth embodiment, as has been described above, since the reverse output and non-reverse output of the differential amplifier are electrically connected to the gates of the different two variable-resistance transistors (FETs) so as to constitute the variable attenuator, dynamic range can be increased as compared with the case where the fixed resistance is interposed in the signal line.

According to the variable attenuator showing the sixth embodiment as well, since the variable-resistance transistor is used in place of the fixed resistance, the value of the resistance (corresponding to the resistance of the transistor Q17) on the signal line can be reduced upon minimum attenuation. Further, the production of noise can be curbed and the insertion loss can be reduced.

Incidentally, the variable attenuator according to the sixth embodiment can also bring about the advantageous effects obtained by the variable attenuator according to the fourth embodiment.

(L) Seventh Embodiment of Variable Attenuator:

A seventh embodiment of a variable attenuator according to the present invention will next be described in detail with reference to the accompanying drawings. Fig. 19 is a circuit diagram showing the variable attenuator according to the seventh embodiment. The same or corresponding elements of structure as those shown in Fig. 18 are identified by like reference numerals.

The variable attenuator according to the seventh embodiment is equivalent to one wherein a variable-resistance transistor (FET) Q18 is provided in addition to the configuration of the variable attenuator according to the sixth embodiment. The variable-resistance transistor Q18 is disposed on a signal line between a signal input terminal T15 and a signal output terminal T14 and is inserted on the terminal T14 side away from the aforementioned variable-resistance transistor Q17. A point where both the transistors Q17 and Q18 are connected to each other, is electrically connected to the source of a transistor Q14. The variable-resistance transistor Q18 is activated by the same gate voltage as that of the transistor Q17.

Accordingly, configurations of connection made among the three transistors Q14, Q17 and Q18 are symmetrical with each other.

Even in the present embodiment, an ac signal is input to the signal input terminal T15 via a dc blocking capacitor and a signal is output from the signal output terminal T14 via a dc blocking capacitor. It is also necessary to maintain potentials at the terminals T15 and T14 as equal as possible to a potential at a terminal T13.

Similarly to the sixth embodiment, a voltage opposite in phase to a control voltage VCONT input to a terminal T11 is applied to the gates of the transistors Q17 and Q18. Further, a voltage, which is in phase with the control voltage VCONT input to the terminal T11, is applied to the gate of the transistor Q14.

Therefore, when the level of the signal output from the signal output terminal T14 is minimized (attenuation is maximized), the control voltage VCONT may be applied in such a way that source-to-drain resistances of the transistors Q17 and Q18 become as large as possible and a drain-to-source resistance of the transistor Q14 becomes as small as possible.

In the sixth embodiment referred to above, the impedance at the terminal T13 as viewed from the signal output terminal T14 becomes so low when such attenuation is maximized, so that the maintenance of the terminals T15 and T14 and the terminal T13 at the same potential is slightly impaired. Since, however, a drain-to-source resistance of the transistor Q18 reaches a maximum in the variable attenuator according to the seventh embodiment, the impedance at the terminal T13 as viewed from the signal output terminal T14 can be kept high at all times.

Both the variable attenuators according to the sixth and seventh embodiments referred to above make it possible to keep high the impedance at the terminal T13 as viewed from the signal output terminal T15 upon maximum attenuation. Further, both the variable attenuators according to the sixth and seventh embodiments make it possible to keep high the impedance at the terminal T13 as viewed from the signal output terminal T15 upon minimum attenuation owing to the fact that the drain-to-source resistance of the transistor Q14 reaches a high resistance value.

Thus, according to the variable attenuator showing the seventh embodiment, since the variable-resistance transistor is provided even on the signal output side, the impedance viewed from the terminal T13 relative to the signal input and output terminals T15 and T14 can be prevented from decreasing, regardless of attenuation, whereby the condition of the same potential can be stably established.

Incidentally, the variable attenuator according to the seventh embodiment can also bring about the advantageous effects obtained by the variable attenuator according to the sixth embodiment.

(M) Eighth Embodiment of Variable Attenuator:

Fig. 20 is a circuit diagram illustrating an eighth embodiment of a variable attenuator according to the present invention. The same or corresponding elements of structure as those shown in Fig. 19 are identified by like or corresponding reference numerals.

The variable attenuator according to the eighth embodiment is equivalent to one obtained by introducing the characteristic technical idea of the variable resistor according to the fourth embodiment into the technical idea of the variable attenuator according to the seventh embodiment.

Namely, the variable attenuator according to the eighth embodiment is configured as follows: The load resistances R11 and R12 in the differential amplifier employed in the seventh embodiment are respectively divided into a plurality of resistances (three resistances R11-1 through R11-3 and R12-1 through R12-3 as shown in the drawing). Further, the variable-resistance transistors Q14, Q17 and Q18 are also respectively divided into the same number of parallel-connected transistors Q14-11 through Q14-13, Q17-11 through Q17-13 and Q18-11 through Q18-13. The gates of the first set of transistors Q14-11 through Q14-13 are respectively supplied with different control voltages obtained by the resistances R12-1 through R12-3, whereas the gates of the second and third sets of transistors Q17-11 through Q17-13 and Q18-11 through Q18-13 are respectively supplied with different control voltages obtained by the resistances R11-1 through R11-3.

As in the variable resistor according to the second or fourth embodiment, a variable-resistance characteristic having a desired inclination with respect to a control voltage VCONT supplied from a terminal T11 can be applied to each of the three (three sets of) variable-resistance transistors Q14, Q17 and Q18.

Thus, according to the variable attenuator showing the eighth embodiment, since the desired variable-resistance characteristic can be applied to each variable-resistance transistor, the impedance at a terminal T13 as viewed from terminals T15 and T14 can be kept constant irrespective of attenuation.

Incidentally, the variable attenuator according to the eighth embodiment can also bring about the advantageous effects obtained by the variable attenuator according to the seventh embodiment.

(N) Fifth Embodiment of Variable Resistor:

A fifth embodiment of a variable resistor according to the present invention will next be described in detail with reference to the accompanying drawings. Fig. 21 is a schematic plan view showing the layout of the variable resistor according to the fifth embodiment on a semiconductor chip.

In the description of the variable resistor according to the first embodiment, the layout on the semiconductor chip was not described. However, one, which has adopted a layout suitable for the variable resistor, constitutes the variable resistor according to the fifth embodiment.

The variable resistor according to the first embodiment is characterized in that the common-source amplifier composed principally of the transistor Q2 is provided to compensate for the product variations in threshold voltage Vth of the variable-resistance transistor Q1 and the variation in temperature. Therefore, the variable resistor is based on the premise that the transistors Q1 and Q2 for compensating for variations in threshold voltage Vth with respect to each other are identical in characteristic to each other.

The variable resistor according to the fifth embodiment is constructed in such a manner that both the transistors Q1 and Q2 are of identical shape with each other and provided so as to be as close as possible to each other as shown in Fig. 21 in order to attain that the transistors Q1 and Q2 for compensating for variations in threshold voltage Vth with respect to each other are identical in characteristic to each other.

Namely, the gate G1, drain D1 and source S1 of the transistor Q1 are respectively of identical shape with the gate G2, drain D2 and source S2 of the transistor Q2. The source S1 of the transistor Q1 and the drain D of the transistor Q2 approach each other at an interval shorter than each of their pattern widths.

Generally speaking, even if the two transistors (FETs) Q1 and Q2 are formed on the same semiconductor chip, a slight difference in characteristic therebetween inevitably occurs from a production viewpoint due to an in-plane distribution of the luminous intensity of a stepper, and the like. Since the slight difference in characteristic therebetween becomes small as the transistors approach each other, both the transistors Q1 and Q2 are arranged side by side in the fifth embodiment.

When the transistors Q1 and Q2 are different in pattern shape from each other, a slight difference in characteristic between the transistors Q1 and Q2 occurs due to a microloading effect of etching and the like even if any intention of establishing the same characteristic is made. Therefore, the pattern shapes of both the transistors Q1 and Q2 are made identical in the fifth embodiment.

Even if a heating source exists inside or outside the chip, both the transistors Q1 and Q2 are kept at temperatures considerably closer to each other if they approach each other. It is therefore possible to reduce the difference in threshold voltage Vth between the transistors Q1 and Q2 due to the temperature dependence of the threshold voltage Vth.

Thus, according to the variable resistor showing the fifth embodiment, since the transistors (FETs) for compensating for variations in threshold voltage Vth with respect to each other are of identical shape with each other and are provided so as to approach each other, a variable resistor can be materialized which is resistant to the influence of both a production variation in threshold voltage Vth and a variation in threshold voltage Vth due to the temperature dependence of the threshold voltage Vth.

(O) Sixth Embodiment of Variable Resistor:

A sixth embodiment of a variable resistor according to the present invention will next be described in detail with reference to the accompanying drawings. Fig. 22 is a schematic plan view showing the layout of the variable resistor on a semiconductor chip.

The variable resistor according to the sixth embodiment is also characterized by the layout of electrode patterns of two transistors Q1 and Q2 for compensating for threshold voltages Vth with respect to each other in a manner similar to the variable resistor according to the fifth embodiment.

In the variable resistor according to the sixth embodiment, the transistors Q1 and Q2 respectively comprise a plurality of gates G1a through G1c, a plurality of drains D1a through D1c and a plurality of sources S1a through S1c, and a plurality of gates G2a through G2c, a plurality of drains D2a through D2c and a plurality of sources S2a through S2c. The same types of electrodes G1a through G1c or G2a through G2c, D1a through D1c or D2a through D2c and S1a through S1c or S2a through S2c that constitute the same transistor Q1 or Q2, are connected to one another by unillustrated wires. Further, partial transistors Q1a (composed of G1a, D1a and S1a) through Q1c of the transistor Q1 and partial transistors Q2a through Q2c of the transistor Q2 are provided in an alternating sequence and closer to each other.

In order to further reduce the difference in threshold voltage Vth between the transistors Q1 and Q2 as compared with the fifth embodiment, the partial transistors Q1a through Q1c of the transistor Q1 and the partial transistors Q2a through Q2c of the transistor Q2 are alternately disposed to average their variations and eventually match the threshold voltages Vth of the transistors Q1 and Q2 with each other.

Thus, according to the variable resistor showing the sixth embodiment, since the transistors Q1 and Q2 are respectively divided into the partial transistors and alternately disposed, a circuit, i.e., a variable resistor can be achieved which is further resistant to the influence of both a production variation in threshold voltage Vth and a variation in threshold voltage Vth due to the temperature dependence of the threshold voltage Vth as compared with the fifth embodiment.

(P) Other Embodiments:

The variable resistor circuit, variable attenuators and variable gain amplifier according to the present invention are not necessarily limited to or by the aforementioned embodiments. Those obtained by modifying their parts will also constitute the present invention. Some examples will be described as follows:

(P-1): Although each transistor has been described as being the MESFET in which the depletion type GaAs has been used as the substrate, even the depletion or enhancement type one may be applied. Further, any FETs such as MOSFET, J-FET and MESFET, or any vacuum tube (the term transistor as defined in claims will include the vacuum tube as necessary) may be applied. Conduction type ones are not limited to N-type ones either.

(P-2): A description has been made of the case where all the circuit elements are integrated on the same semiconductor chip. However, only part of the circuit elements may be integrated. Alternatively, all the circuit elements may be made up of individual parts.

(P-3): In the circuit having the common-source amplifier, the self-bias resistances R2 and R5 have been employed in the amplifier. However, these self-bias resistances R2 and R5 may be omitted from the amplifier.

(P-4): In the circuit having the differential amplifier, the self-bias resistance R13 is used for the transistor Q13 for the source of current and the gate of the transistor Q13 is connected to ground. However, the self-bias resistance R13 may be omitted. Further, the gate of the transistor Q13 may be supplied with an arbitrary voltage.

(P-5): In the above description, the high source potentials of the amplifier (common-source amplifier or differential amplifier) for compensating for the characteristic of each variable-resistance transistor and the amplifier provided at the signal input stage are respectively set to a positive potential and the low source potentials thereof are respectively set to a ground potential. It is however needless to say that the high source potentials and the low source potentials may be set to the ground potential and a negative potential respectively.

(P-6): In the above description, the terminal T3 or T13 that provides for the drain potential of the variable-resistance transistor uninterposed in the signal line, is supplied with the source potential. However, the terminal T3 or T13 may be connected to ground or a point supplied with any potential. Even in this case, it is of course necessary to maintain the potential at the terminal T3 or T13 and the potential at the terminal T4 or T14 at the same potential. When the signal input terminal T5 or T15 is provided, it is necessary to maintain the potential at the terminal T3 or T13 and the potential at the terminal T5 or T15 at the same potential.

However, the terminal T3 or T13 must be grounded on an ac basis.

(P-7): In the above description, the drain of the variable-resistance transistor is electrically connected to the terminal T3 or T13. However, the source and drain of the transistor may be reversely connected.

(P-8): The technical characteristics of the variable resistor circuit according to the fifth and sixth embodiments, i.e., the technical characteristic that the electrode patterns of the transistors Q1 and Q2 employed in the variable resistor according to the first embodiment are made identical and provided so as to approach each other, may be applied to the plurality of transistors for compensating for the threshold voltages Vth with respect to each other, which are employed in other variable resistor circuit, variable attenuators and variable gain amplifier or the like. Of course, they may be applied to three or more transistors.

(P-9): A fixed resistance, a signal input terminal and a signal output terminal may be added to the variable resistor according to the second or fourth embodiment so as to constitute a variable attenuator.

(P-10): In the variable gain amplifier according to the aforementioned embodiment, the amplifier is provided at the signal input stage of the variable attenuator according to the third embodiment. However, the amplifier may be provided at the signal input stage of the variable attenuator according to other embodiment so as to constitute the variable gain amplifier of the present invention. In this case, the amplifier provided at the signal input stage is not limited to or by the common-source one. Amplifiers having other configurations, such as a differential amplifier, etc. may be used.

(P-11): Even if a variable-resistance transistor supplied with a control voltage is single, amplified control voltages may be supplied from divided points of a load resistance.

According to a variable resistor of the present invention, since a control voltage amplifier, which amplifies an input control voltage and is composed of one or more transistors, and a first transistor used as a resistor, which has a control electrode supplied with the control voltage amplified by the control voltage amplifier and is set such that the value of a resistance between first and second electrodes thereof is varied according to the supplied control voltage, are provided, a variable resistor capable of compensating for product variations in characteristic of the first transistor used as the resistor and a variation in temperature of the first transistor can be materialized.

According to a variable attenuator of the present invention, since a signal input terminal, a signal output terminal and one or a plurality of attenuation resistances series-connected to a signal line between these signal input and output terminals and whose at least one ends are electrically connected to second electrodes of first transistors, are provided in addition to the configuration of the variable resistor according to the present invention, a variable attenuator can be materialized which is capable of reducing a variation in characteristic due to variations in product and a variation in temperature.

According to other variable attenuators of the present invention, since two or more resistances series-connected to a signal line between a signal input terminal and a signal output terminal and transistors used as variable resistor circuit, which respectively include second electrodes connected between these resistances or between the resistances and the signal input terminal without overlapping, first electrodes connected to ground and control electrodes each connected to a control terminal and which are identical in number to the resistances, are provided, a smooth control voltage vs. output voltage (attenuation) characteristic can be obtained as compared with the use of the single variable-resistance transistor. Further, the provision of these elements makes it easy to achieve a desired control voltage vs. output voltage characteristic owing to the selection of the values of the resistances.

According to a variable gain amplifier of the present invention, since a variable attenuator according to the present invention and an amplifier provided at a stage preceding a signal input terminal of the variable attenuator, for amplifying an ac signal, are provided, a variation in characteristic due to variations in product and a variation in temperature can be reduced or a desired smooth variable gain characteristic can be achieved.

According to a transistor circuit of the present invention, since electrode patterns of transistors that compensate for variations in characteristic and a variation in characteristic each other, are of identical shape with each other and disposed on a semiconductor chip so as to approach each other, the transistor circuit can provide sufficient compensation for the variation in characteristic of each transistor.

While the present invention has been described with reference to the illustrative embodiments, this description is not intended to be construed in a limiting sense. Various modifications of the illustrative embodiments, as well as other embodiments of the invention, will be apparent to those skilled in the art on reference to this description. It is therefore contemplated that the appended claims will cover any such modifications or embodiments as fall within the true scope of the invention.

**Claims**

1.  A variable resistor circuit comprising:

    a first control voltage amplifier for amplifying a input control voltage, the first control voltage amplifier comprising a first transistor which having a first control electrode, a first main electrode and a second main electrode , a first resistance coupling through a first node and a second resistance coupling to the second main electrode;

    a variable resistor comprising a second transistor having a second control electrode coupling through the first node, a third main electrode and a fourth electrode; and

    the first and second transistors having substantially same a characteristic of a Vth corresponding to temperature.

2.  The variable resistor circuit as set forth in claim 1 above, wherein the first control voltage amplifier further having a third resistance coupling to the first resistance through a second node, the variable resistor further having a third transistor which having a third control electrode coupling to the second node, a fifth main electrode coupling to the third main electrode, and a sixth main electrode coupling to the fourth main electrode, and which having substantially same to the first and second transistors a characteristic of a Vth corresponding to temperature.

3.  The variable resistor circuit as set forth in claim 1 above, wherein the variable resistor further having first input and output terminals coupling to the fourth main electrode through the a third node and having a fourth resistance coupling between the third node and the first output terminal.

4.  A variable attenuator circuit comprising:

    a fourth transistor having a fourth control electrode, a seventh main electrode and a eighth electrode;
    a fifth transistor having a fifth control electrode coupling to the fourth control electrode, a ninth main electrode coupling to the seventh main electrode and a tenth main electrode coupling to the eighth main electrode;
    a fifth resistance coupling between the eighth and tenth main electrodes;
    a second input terminal;
    a sixth resistance coupling between the eighth main electrode and the second input terminal; and
    a second output terminal coupling to the tenth main electrode.

5.  A variable gain amplifier comprising:

    a variable attenuator circuit comprising a fourth transistor having a fourth control electrode, a seventh main electrode and a eighth electrode, a fifth transistor having a fifth control electrode coupling to the fourth control electrode, a ninth main electrode coupling to the seventh main electrode and a tenth main electrode coupling to the eighth main electrode, a fifth resistance coupling between the eighth and tenth main electrodes, a second input terminal, a sixth resistance coupling between the eighth main electrode and the second input terminal, and a second output terminal coupling to the tenth main electrode; and

a second control voltage amplifier for amplifying a input control voltage, the second control voltage amplifier comprising a sixth transistor which having a sixth control electrode, a eleventh main electrode and a twelfth main electrode, a seventh resistance coupling to the eleventh main electrode through a fourth node, and a eighth resistance coupling to the twelfth main electrode, and the amplified input control voltage being inputted the fourth control electrode through the fourth node.

6. The variable resistor circuit as set forth in claim 1 and 2 above, wherein the first control voltage amplifier comprising a differential circuit.

7. A variable gain amplifier comprising:

a variable attenuator circuit comprising a fourth transistor having a fourth control electrode, a seventh main electrode and a eighth electrode, a fifth transistor having a fifth control electrode coupling to the fourth control electrode, a ninth main electrode coupling to the seventh main electrode and a tenth main electrode coupling to the eighth main electrode, a fifth resistance coupling between the eighth and tenth main electrodes, a second input terminal, a sixth resistance coupling between the eighth main electrode and the second input terminal, and a second output terminal coupling to the tenth main electrode; and
a third control voltage amplifier for amplifying a input control voltage and comprising a differential circuit.

Fig. 1

Fig. 2

PRIOR ART

Fig. 3
PRIOR ART

Fig. 4

Fig. 5

Fig. 6

Fig. 7

Fig. 8

$V_{OUT}(mV)$

1.0

0.5

-1.0   -0.5   0   0.5

$V_{CONT}(V)$

Fig. 9

Fig. 10

Fig. 11

Fig. 12

Fig.13

Fig.14

Fig.15

Fig.16

Fig. 17

Fig. 18

Fig. 19

Fig. 20

Fig. 21

Fig. 22